# EUROPEAN PATENT SPECIFICATION

(11) **EP 1 146 613 B1**
(45) Date of publication and mention of the grant of the patent: **23.06.2010**
(21) Application number: 00927782.3
(22) Date of filing: 17.05.2000
(51) Int. Cl.: H01S 5/024

(54) **SEMICONDUCTOR LASER MODULE AND METHOD OF DRIVING SEMICONDUCTOR LASER MODULE**
HALBLEITERLASERMODUL UND VERFAHREN ZUR ANSTEUERUNG EINES HALBLEITERLASERMODULES
MODULE LASER A SEMI-CONDUCTEURS ET SON PROCEDE DE COMMANDE

(30) Priority: 01.11.1999 JP 31099299
(43) Date of publication of application: 17.10.2001
(73) Proprietor: THE FURUKAWA ELECTRIC CO., LTD., Chiyoda-ku Tokyo 100-8322 (JP)
(72) Inventor: AIKIYO, Takeshi,, Tokyo 100-8322 (JP)
(74) Representative: Khan, Mohammed Saiful Azam
(86) International application number: PCT/JP2000/003147
(87) International publication number: WO 2001/033680

(56) References cited:
- JP-A- 08 213 688
- JP-A- 11 126 939
- JP-A- 52 061 982
- JP-U- 02 015 762
- JP-U- 02 047 077
- JP-U- 62 149 858
- US-A- 4 571 728
- US-A- 5 515 682
- US-A- 5 845 031

## Description

### Technical field of the invention

The present invention relates to a semiconductor laser module used in the field of optical transmissions and a method for driving the semiconductor laser module, and in particular the invention provides a transmission device equipped with the semiconductor laser module.

### Background of the invention

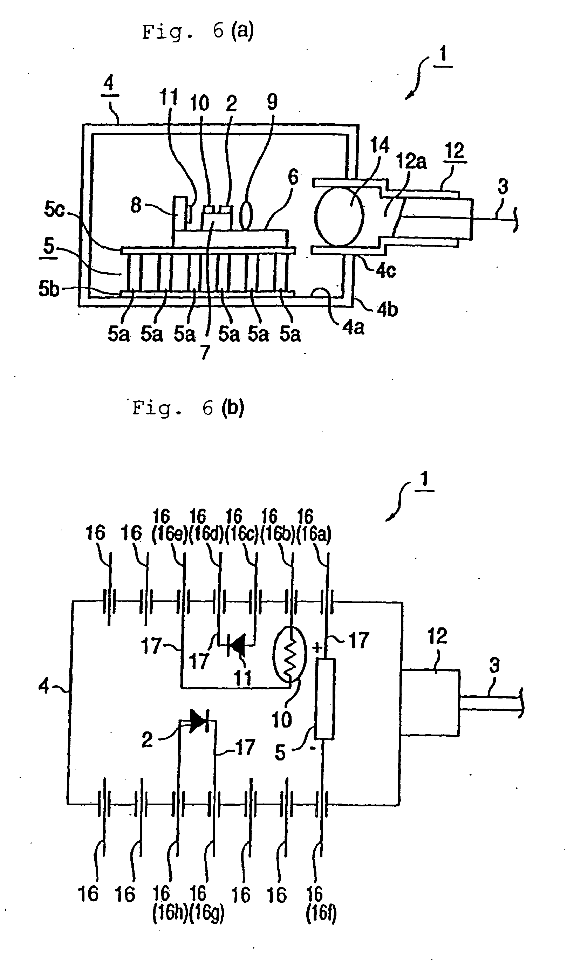

FIG. 6(a) is a view exemplarily showing one configurational example of a semiconductor laser module, in cross section. FIG. 6(b) shows one example of electric wiring diagram of the semiconductor laser module shown in the same drawing 6(a). The semiconductor laser module 1 shown in FIG. 6(a) is such that a semiconductor laser element 2 and an optical fiber 3 are optically coupled to each other to be made into a module.

That is, as shown in FIG. 6(a), a thermomodule 5 is provided on the inner bottom wall plane 4a of a package 4. The thermomodule 5 is constructed in such a form that a plurality of Peltier elements 5a are placed between plate members 5b and 5c (the first substrate and the second substrate) which are insulation substrates made of, for example, alumina, aluminum nitride, etc. In this example, the plate member 5b is fixed on the inner bottom wall plane 4a of the package 4, and the heat radiation side of the Peltier elements 5a are secured on the plate member 5b by soldering, and the plate member 5c is secured on the heat absorption side of the Peltier elements 5a by soldering.

Such a thermomodule 5 changes the heat emission action (heating action) and the heat absorption action (cooling action) in response to orientation of a current which flows in the Peltier elements 5a, wherein the heat emission quantity and heat absorption quantity vary in response to the amount of current flow of the Peltier elements 5a.

A substrate 6 which is a member for attaching components is installed and fixed on the upper side of the thermomodule 5 (that is, on the plate member 5c) by solder (for example, InPbAg eutectic solder (melting point: 148°C)). Supporting members 7 and 8, and a lens 9 are fixed on the upper side of the substrate 6. On the supporting member 7, the semiconductor laser element 2 is disposed, and at the same time, a thermister 10 for detecting the temperature of the semiconductor laser element 2 is provided. On the supporting member 8, a photo diode 11 is disposed, which monitors a light emitting state of the semiconductor laser element 2. As the semiconductor laser element 2, those having signal light wavelength bands of, for example, 1310nm and 1550nm, and wavelength bands of pumping light for optical fiber amplifiers such as a 1480nm band and a 980nm band, etc., may be used.

A through hole 4c is provided at the side wall 4b of the package 4, and an optical fiber supporting member 12 is fitted in the through hole 4c and mounted therein. The optical fiber supporting member 12 has an insertion hole 12a, wherein the end portion side of an optical fiber 3 is introduced from the outside of the package 4 through the inside of the insertion hole 12a. Also, a lens 14 is disposed inside the insertion hole 12a with a spacing between it and the end of the optical fiber 3.

As shown in FIG. 6(b), a plurality of lead pins 16 (14 pins in the example shown in FIG. 6(b)) are formed at the package 4 so as to protrude upward therefrom. In addition, connecting means 17 such as conductor patterns and lead wires, etc. are provided in the package 4, which electrically connect the semiconductor laser element 2, thermomodule 5, thermister 10, and photo diode 11 to the abovementioned lead pins 16. By the connecting means 17 and lead pins 16, the semiconductor laser element 2, thermomodule 5, thermister 10 and photo diode 11 can, respectively, be electrically connected to a drive controlling means (not illustrated) for driving the semiconductor laser module.

In detail, in the example shown in FIG. 6(b), the semiconductor laser element 2 is electrically connected to the drive controlling means by the connecting means 17 and lead pins 16 (16g and 16h), the thermomodule 5 by the connecting means 17 and lead pins 16 (16a and 16f), the thermister 10 by the connecting means 17 and lead pins 16 (16b and 16e), and the photo diode 11 by the connecting means 17 and lead pins (16c and 16d).

A semiconductor laser module 1 shown in FIG. 6 is constructed as described above. When such a semiconductor laser module 1 is electrically connected to the drive controlling means and current flown from the drive controlling means to the semiconductor laser element 2 of the semiconductor laser module 1, laser light is emitted from the semiconductor laser element 2. The emitted laser light is condensed by a optical coupling system consisting of the lenses 9 and 14 and is permitted to enter the optical fiber 3, wherein the light propagates through the optical fiber 3 and is used for appointed applications.

However, the intensity and wavelength of laser light emitted from the semiconductor laser element 2 fluctuate in response to the temperature of the semiconductor laser element 2 itself. Therefore, in order to control the intensity and wavelength of the laser light at constant, the drive controlling means controls the orientation of a current of the thermomodule 5 and the amount of the current thereof on the basis of the output value outputted from the thermister 10, thereby controlling the heating action and cooling action of the thermomodule 5. Through control by the thermomodule 5, the semiconductor laser element 2 can be kept at an almost constant temperature, whereby the intensity and wavelength of the laser light emitted from the semiconductor laser element 2 can be kept constant.

However, there is a case where an abnormal situation occurs, in which an overcurrent in the heating direction which may heat the thermomodule 5 flows in the thermomodule 5 , for example, erroneous operations or the occurrence of overvoltage. In this case, the thermomodule 5 is extraordinarily heated to cause components such as the semiconductor laser 2, substrate 6, lens 9, etc., to be heated quickly (for example, so quickly that the indication temperature of the thermister 10 rises to more than 200°C in, for example, 10 seconds).

Herein, in a case where the plate member 5c of the thermomodule 5 is thermally connected to the side wall of the package 4 and the optical fiber supporting member 12, a portion, part of the heat emitted from the thermomodule 5 is discharged outside via the side wall of the package 4 and the optical fiber supporting member 12. Therefore, when the thermomodule 5 is extraordinarily heated as described above, a part of the high temperature heat is discharged from the thermomodule 5 to the outside via the optical fiber supporting member 12, the amount of heat transmitted to components on the thermomodule 5 such as the semiconductor laser element 2, lens 9, etc., is suppressed to relieve the temperature rise of the components on the thermomodule 5.

But, in the example shown in FIG. 6, the components on the thermomodule 5 are thermally isolated from the sidewall of the package and the optical fiber supporting member 12. Therefore, there is almost no case where the heat of the components on the thermomodule 5 is discharged to the outside of the package 4 through the side wall of the package 4 and the optical fiber supporting member 12. In such a case, when the thermomodule 5 is extraordinarily heated to a high temperature, the high temperature heat of the thermomodule 5 is transmitted to the components on the thermomodule 5 and is accumulated there. Accordingly, the temperature rise of the components on the thermomodule 5 becomes remarkable, and the following situations which constitute problems may occur.

For example, as described above, wherein the temperature of the semiconductor laser element 2 is raised to a high temperature due to high temperature heating of the thermomodule 5 resulting from an overcurrent flowing in the heating direction, such a problem occurs, where a defect in crystal of the semiconductor laser element 2 grows and the characteristics of the semiconductor laser element 2 deteriorate to a large extent.

In addition, as described above, the substrate 6 is fixed on the plate member 5c of the thermomodule 5 by, for example, solder (thermal-fusion type connection material) such as InPbAg eutectic solder (melting point: 148°C). For this reason, where the thermomodule 5 is heated to an extraordinarily high temperature, the solder is fused to cause the substrate 6 to be shifted from its (original, proper, aligned, fixed) position. The positional shift of the substrate 6 causes the semiconductor laser element 2 and the lens 9 to shift from their originally aligned positions, whereby such a problem occurs, where a optical decoupling arises. The misalignment causes the semiconductor laser element 2 and lens 9 to shift with respect to the optical fiber 3. In particular, if an angular shift occurs in the semiconductor laser element 2 with respect to the optical fiber 3, resulting from the positional shift of the substrate 6, for example, an only 0.2° angular shift could causes 95% of the optical output to be lost and brings about a remarkable lowering of the optical output.

Further, the glass-made lens 9 is adhered to , for example, a metal-made holder, utilizing glass solder which is fixed at the substrate 6 in order to fix the lens 9 to the substrate 6. In this case, as described above, when the thermomodule 5 is quickly overheated, a crack occurs at the conjunction point (glass solder) between the lens 9 and the metal holder by a large difference in the thermal expansion ratio between glass and metal. Such a problem arises, wherein, by occurrence of the crack, the lens 9 comes off from the metal holder, and the optical coupling between the semiconductor laser element 2 and the optical fiber 3 may be disrupted.

Still further, as described above, since the Peltier element 5a, and plate members 5b and 5c are fixed , assembled together by solder, the abovementioned solder is melted, whereby, for example, the Peltier element 5a comes off, and the thermomodule 5 itself may be damaged.

The invention was developed to solve the abovementioned problems, and it is therefore an object of the invention to provide a semiconductor laser module that can prevent overcurrent and overvoltage onto a thermomodule in the heating direction whereby evading problems resulting from overcurrent, and a method for driving the same semiconductor laser module.

US-A-5515682 discloses a semiconductor laser module comprising a Peltier device equipped with an over-current limiting circuit.

### DISCLOSURE OF THE INVENTION

There is provided a semiconductor laser module as claimed in claim 1. There is also provided a semiconductor laser module according to another embodiment, which has a semiconductor laser element, a thermomodule for adjusting the temperature of the semiconductor laser element, an optical fiber optically coupled to laser light emitted from the semiconductor laser element, in which the thermomodule is constructed so as to vary and adjust the temperature of a semiconductor laser in response to the amount of a current in the thermomodule, comprises any one or both of an overcurrent limiting means to suppress overcurrent that flows into the thermomodule, and an overvoltage limiting means to suppress that overvoltage is applied to the thermomodule.

Also, in another embodiment, in addition the semiconductor laser module described above, a semiconductor laser module is further provided with a reverse current flow prevention means which prevents a current from flowing into the thermomodule in the reverse direction of the drive current direction of the thermomodule.

Preferably, the thermomodule is constructed so that it can vary a heating action and a cooling action in response to the orientation of the flowing current, wherein the overcurrent limiting means is connected to a current flowing channel by which a current in the heating direction to cause the thermomodule to carry out a heating action is permitted to flow.

Still preferably, the current flowing channel by which a current in the heating direction is caused to flow is provided with a bypass channel by which the upstream side and downstream side of the thermomodule are connected to each other, bypassing the thermomodule, and a resistor intervenes in the bypass channel, and at the same time, a diode is provided in series with the resistor such that the current direction for heating made to be a forward direction, wherein the bypass channel, resistor and diode construct an overcurrent limiting means to relieve a flow of the overcurrent in the heating direction into the thermomodule by shunting the current in the heating direction to the thermomodule and bypass channel.

In another embodiment, a semiconductor laser module according to the invention is composed so that the thermomodule is constructed by placing Peltier elements between the first substrate and second substrate, a semiconductor laser element is disposed at any one of the first and the second substrate, thereby being thermally connected to the thermomodule, and a lens is provided to condense laser light emitted from the semiconductor laser and to introduce it into an optical fiber,
wherein the lens is thermally connected to a substrate at the side, on which a semiconductor laser element of the thermomodule is disposed, via a thermally melting connection material by which a member for attaching the corresponding lens is fixed.

In still another embodiment, an optical fiber that constitutes a semiconductor laser module according to the invention may be a lensed optical fiber in which a lens to condense laser light emitted from a semiconductor laser element is formed at the tip end portion into which the laser light is made incident.

Also, as another preferable example of the thermomodule, a thermomodule is constructed by placing Peltier elements between the first substrate and the second substrate, and a semiconductor element is disposed on any one of the first substrate and the second substrate thereby being thermally connected to the thermomodule, wherein the semiconductor laser element and thermomodule are disposed and accommodated in a package which is provided with a through hole communicating from the inside of the package to the outside thereof, an optical fiber supporting member consisting of a thermally conducting member is inserted into and fitted in the through hole, an end portion side of an optical fiber is introduced from the outside of a package into the inside thereof through a hole provided in the optical fiber supporting member, the substrate of the thermomodule at the side, where a semiconductor laser element is disposed, is thermally isolated from the optical fiber supporting member, and the discharge of heat from the substrate of the thermomodule at the side, where the semiconductor laser element is disposed, to the outside of the package via the optical fiber supporting member is limited.

There is also provided a method for driving a semiconductor laser module as claimed in Claim 11. In another embodiment, there is also provided a method for driving a semiconductor laser module having a semiconductor laser element, a thermomodule for adjusting the temperature of the semiconductor laser element, and an optical fiber optically coupled to laser light emitted from the semiconductor laser element, comprising the steps of: thermally connecting the thermomodule to the semiconductor laser element; adjusting the temperature of the semiconductor laser element in response to the amount of a current flowing into the thermomodule; and suppressing the overcurrent flow into the thermomodule by providing an overcurrent flow limiting means in a current flow channel to the thermomodule.

In another embodiment, a method for driving a semiconductor laser module according to the invention resides in a method for driving a semiconductor laser module having a semiconductor laser element, a thermomodule for adjusting the temperature of the semiconductor laser element, and an optical fiber optically coupled to laser light emitted from the semiconductor laser element, wherein the thermomodule is constructed so that it changes the heating action and the cooling action in response to the orientation of a current flow, comprising the steps of: thermally connecting the thermomodule to a semiconductor laser element; providing a current path, by which a current is supplied in the heating direction to cause the thermomodule to carry out a heating action, with a bypass channel which connects the upstream side and downstream side of the thermomodule, bypassing the thermomodule; interposing a resistor in the bypass channel, and relieving the overcurrent flow to the thermomodule in the heating direction by shunting the current in the heating direction to the thermomodule and to the bypass channel.

There is also provided a transmission device as claimed in claim 13.

There is also provided a transmission device which is provided with a semiconductor laser module having semiconductor laser element, a thermomodule for adjusting the temperature of the semiconductor laser element, and an optical fiber optically coupled to laser light emitted from the semiconductor laser element; wherein the thermomodule is constructed so that it variably adjust the temperature of a semiconductor laser element in response to an amount of a current that flows into the thermomodule, and wherein the transmission device is provided with any one or both of an overcurrent limiting means to suppress an overcurrent from flowing into the thermomodule and an overvoltage limiting means to suppress overvoltage from being applied to the thermomodule.

In the embodiments described, the overcurrent limiting means can suppress an overcurrent from flowing into the thermomodule when the overcurrent occurs resulting from an mis-operation or the occurrence of overvoltage. Thus, since the overcurrent flow can be prevented from flowing into the thermomodule, it is possible to prevent various problems resulting from an overcurrent flow into the thermomodule in the heating direction. Therefore, it becomes possible to remarkably improve the optical coupling, durability and reliability of the semiconductor laser module. Still further, there are embodiments that can bring about the following effects.

That is, an overcurrent limiting means is provided inside or outside the semiconductor laser module, and an overvoltage limiting means is provided for the semiconductor laser module if necessary, whereby an overcurrent flowing into a thermomodule and overvoltage application thereto can be suppressed. With such a construction, it is possible to evade various problems resulting from an overcurrent flow into the thermomodule and overvoltage application thereto.

Where an overcurrent limiting means is provided in a current path which permits a current in the heating direction, which cause the thermomodule to perform a heating action, to flow into the thermomodule, it is possible to suppress the overcurrent flow into the thermomodule in the heating direction by the overcurrent limiting means. If an overcurrent in the heating direction is supplied into the thermomodule, the thermomodule is overheated to an extraordinarily high temperature, resulting in various problems. On the other hand, as described above, since the overcurrent limiting means is provided to suppress the overcurrent in the heating direction, it is possible to prevent various problems from occurring, which may result from the overcurrent flowing into the thermomodule in the heating direction. That is, deterioration of the performace of a semiconductor laser element, optical decoupling, optical coupling disruption due to a coming off of a lens, and breakage of the thermomodule, all of which result from extraordinary heating of the thermomodule, can be prevented from occurring.

Where the overcurrent limiting means is comprising a bypass line, a resistor, and a diode, although being simple in structure, it is possible to suppress the overcurrent flow into the thermomodule.

Where a substrate of the thermomodule at the side at which a semiconductor laser element is disposed, is thermally isolated from the optical fiber supporting member, and the discharge of heat from the substrate of the thermomodule to the outside of the package via the optical fiber supporting member is limited, when an overcurrent flows to the thermomodule in the heating direction, high temperature heat emitted from the thermomodule is not discharged to the outside of the package and almost all the heat is transmitted to and accumulated in components such as the semiconductor laser element, etc., which are thermally connected to the thermomodule, whereby a quick temperature rise occurs in those components, possibly leading to various serious problems. If an overcurrent limiting means which is a characteristic of the invention is provided in such a construction, it is possible to suppress the overcurrent flow to the thermomodule in the heating direction, whereby the serious problems can be effectively prevented from occurring.

### BRIEF DESCRIPTION OF THE DRAWING

FIG. 1 is an explanatory view showing one example of electric wiring characteristic of a semiconductor laser module according to a first embodiment of the invention;
FIG. 2 is an explanatory view showing one example of electric wiring characteristic of a semiconductor laser module according to a second embodiment of the invention;
FIG. 3 is an explanatory view showing another structural example of a semiconductor laser module according to the invention;
FIG. 4 is an explanatory view showing still another embodiment of the invention;
FIG. 5 is an explanatory view showing further another embodiment of the invention; and
FIG. 6(a) is an explanatory view showing one structural example of a semiconductor laser module, and FIG. 6(b) is an explanatory view showing a prior art electric wiring example of the semiconductor laser module.

### BEST MODE FOR CARRYING OUT THE INVENTION

In order to describe the invention in further detail, a description is given of the invention with reference to the accompanying drawings showing the embodiments thereof.

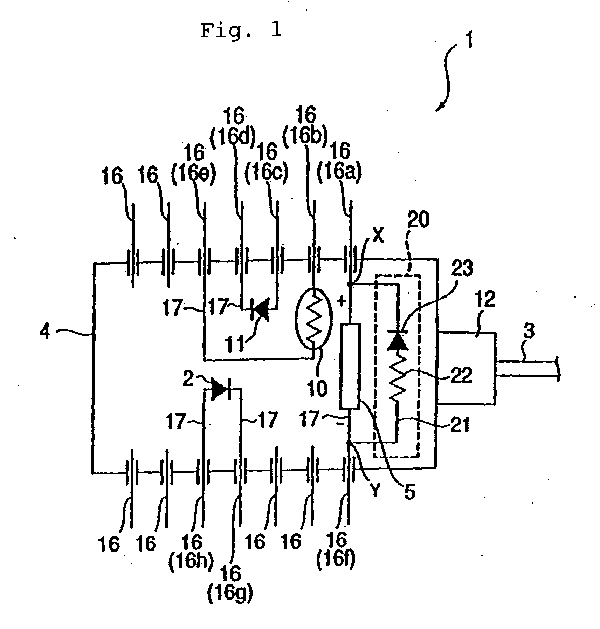

FIG. 1 shows an example of electric wiring characteristic of a semiconductor laser module according to the first embodiment of the invention. In the first embodiment, a characteristic point resides in that, as shown in FIG. 1, an overcurrent limiting circuit 20 which is an overcurrent limiting means (also functioning as a reverse current flow limiting means) is provided. The construction other than the above is similar to the semiconductor laser module illustrated in FIG. 6. In the description of the first embodiment, parts which are identical to those in the semiconductor laser module shown in FIG. 6 are given the same reference numbers, and overlapping description thereof is omitted or simplified.

The semiconductor laser module 1 is often used in surroundings whose temperature is higher than normal, therefore it is often assumed that the thermomodule 5 carries out only a cooling action. However, in the first embodiment, taking into consideration cases where the thermomodule 5 carries out not only the cooling action but also a heating action, an overcurrent limiting circuit 20 as shown below is provided in a package 4.

That is, in the first embodiment, the overcurrent limiting circuit 20 is comprising a bypass line 21, a resistor 22, and a diode 23.

In FIG. 1, one end side of the bypass line 21 is connected to point X at the lead pin 16a side from the thermomodule 5, and the other end side of the bypass line 21 is connected to point Y at the lead pin 16f side from the thermomodule 5.

The first embodiment is constructed so that the thermomodule 5 carries out a heating action, when a current flows in a direction from the lead pin 16f through the lead pin 16a, and so that the thermomodule 5 carries out a cooling action, when current flows in the direction from the lead pin 16a through the lead pin 16f. In other words, the bypass line 21 is provided to connect the upstream side Y and downstream side X of the thermomodule 5 in the current flow channel in the heating direction of the thermomodule 5, bypassing the thermomodule 5.

A resister 22 intervenes in the bypass line 21, and at the same time, a diode 23 in which the current flow direction for heating the thermomodule 5 is made forward direction, is connected in series to the resistor 22.

The semiconductor laser module 1 shown in the first embodiment is constructed as described above. Hereinafter, a brief description is given of examples of circuit operation of the abovementioned overcurrent limiting circuit 20. For example, the semiconductor laser module is electrically connected to a drive controlling means for driving the semiconductor laser module, through lead pins 16. In this state, in a case where, by the drive controlling means, a current oriented from the lead pin 16a to the lead pin 16f (a current in the normal direction for driving a thermomodule) flows, that is, a current flows in the cooling direction for causing the thermomodule 5 to carry out a cooling action, the diode 23 of the abovementioned overcurrent limiting circuit 20 turns off, whereby the current in the cooling direction does not flow into the bypass line 21, but all of the current flows into the thermomodule 5.

On the contrary, where a current (reverse current) oriented from the lead pin 16f to the lead pin 16a flows, that is, a current flows in the heating direction by which the thermomodule is caused to carry out a heating action, the diode 23 is turned on, whereby a current in the heating direction is shunted to the thermomodule 5 and bypass path 21 in proportion to the ratio of the resistance value of the thermomodule 5 to that of the resistor 22.

In a case where an overcurrent occurs in the heating direction, the overcurrent is shunted into the thermomodule 5 and bypass line 21 as described above, whereby, in comparison with a case where all the overcurrent flows into the thermomodule 5, the overcurrent flowing into the thermomodule 5 can be relieved. Also, the resistance value of the resistor 22 may be adequately established in compliance with specifications.

In the first embodiment, as described above, the substrate (plate member (herein, the plate member 5c)) of the thermomodule 5 at the side where a semiconductor laser element is disposed is thermally isolated from the sidewall of the package 4 and the optical fiber supporting member 12. Therefore, in the circuit configuration of the prior art example shown in FIG. 6(b), when an overcurrent flows to the thermomodule 5 in the heating direction, high temperature heat of the thermomodule 5 resulting from the overcurrent is not discharged to the outside of the package 4 via the sidewall thereof and the optical fiber supporting member 12, leading to the heat accumlation in components on the thermomodule 5 and likely to various problems arising therefrom.

On the contrary, in the first embodiment, the overcurrent limiting circuit 20 is provided, by which a reverse overcurrent flow to the thermomodule 5 in the heating direction may be relieved (limited). Therefore, it is possible to evade various problems resulting from the overcurrent flow to the thermomodule 5 in the heating direction.

That is, since it is possible to suppress excessive heating of the thermomodule 5, which results from the overcurrent flowing in the heating direction, the semiconductor laser element 2 can be prevented from being heated to a high temperature. Accordingly, the growth of defects in crystal of the semiconductor laser element 2 due to the high temperature heating can be prevented from occurring, whereby it is possible to prevent the characteristics of the semiconductor laser element 2 from deteriorating.

In addition, it is possible to prevent a thermal fusion connecting material such as solder, by which a substrate 6 being a member for attaching a semiconductor laser element 2 and components such as lens 9, etc., is connected to the thermomodule 5, from being melted as a result of high temperature heating of the thermomodule 5, whereby it is possible to prevent the substrate 6 from shifting in position. Therefore, since the positional shift of the semiconductor laser element 2 and lens 9 with respect to the optical fiber 3 can be evaded, an optical decoupling (misalignment) between the optical fiber 3 and the semiconductor laser element 2 can be prevented from occurring, thereby preventing a lowering of optical output.

Still further, it is possible to prevent generation of cracks at the joint between the lens 9 and metallic holder which originates from a quick temperature rise at the substrate 5c side of the thermomodule 5. Thereby, it is possible to prevent the coming off of a lens 9 originated from the generation of cracks , and to avoid such asituation where the optical coupling of the semiconductor laser element 2 and optical fiber 3 may be disrupted.

Also, since it is possible to prevent solder between the Peltier element 5a and plate members 5b and 5c from being melted, breakage of the thermomodule 5 itself can be avoided.

As described above, by providing an overcurrent limiting circuit 20 which is characteristic in the first embodiment, it is possible to prevent various problems from occurring due to a reverse overcurrent flowing into the thermomodule 5 in the heating direction. Therefore, optical coupling, durability and reliability of a semiconductor laser module 1 can be remarkably improved.

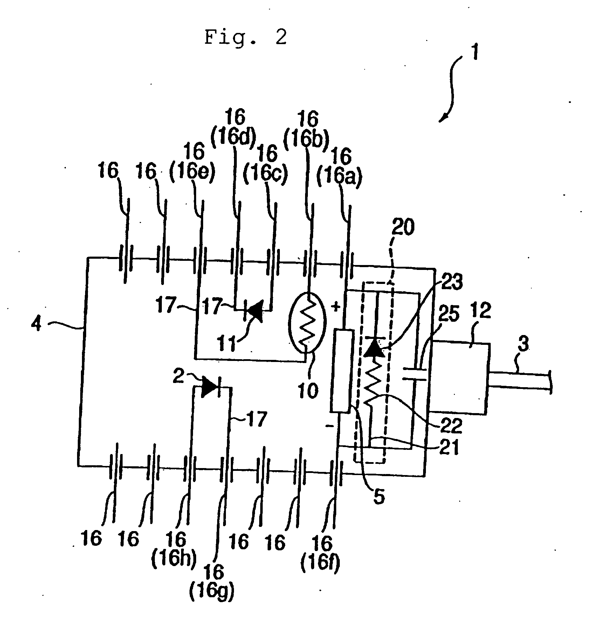

Hereinafter, a description is given of the second embodiment of the invention. A characteristic point at which the second embodiment differs from the abovementioned first embodiment resides in that, as shown in FIG. 2, a capacitor 25 for a surge current flow is provided in parallel to the thermomodule 5. The construction other than this is similar to that of the first embodiment. In the following description of the second embodiment, parts which are identical to those in the first embodiment are given the same reference numbers, and overlapping description thereof is omitted.

In the second embodiment, as described above, since the capacitor 25 is provided in parallel to the thermomodule 5, no surge current, which is an instantaneous large current, is allowed to flow into the thermomodule 5 since the surge current flows into the capacitor 25 should any surge current occur. Therefore, it is possible to prevent the thermomodule 5 from being damaged due to any surge current flow.

That is, the frequency of a surge current is high, and the higher the frequency becomes in a capacitor, the smaller the impedance thereof becomes. Therefore, even though a surge current is generated and tries to enter the thermomodule 5, almost all of the surge current will flow into the capacitor 25, whereby it is possible to suppress the surge current from flowing into the thermomodule 5, and to prevent the thermomodule from being damaged due to the surge current. Also, there is a fear that components on the thermomodule 5 will be subjected to a quick temperature rise and various problems occur as described above if a surge current flows into the thermomodule 5 in the heating direction. Such a surge current flow to the thermomodule 5 can be prevented by the capacitor 25 in the second embodiment as described above, and therefore, various problems such as deterioration of the characteristics of the semiconductor laser element 2, an optical decoupling between the semiconductor laser element 2 and the optical fiber 3, and disruption of the optical coupling due to a coming-off of a lens, can be securely prevented from occurring.

According to the second embodiment, as in the first embodiment, since an overcurrent limiting circuit 20 is provided, it is possible to suppress (limit) a reverse overcurrent flow to the thermomodule 5 in the heating direction by the abovementioned overcurrent limiting circuit 20 as in the first embodiment whereby various problems arising from the overcurrent flow in the heating direction can be prevented. Furthermore, as described above, since the capacitor 25 is provided in parallel to the thermomodule 5, the capacitor 25 can prevent various problems from occurring due to a surge current flow.

In addition, the invention is not limited to the abovementioned respective embodiments, but it may be subjected to various modifications or embodiments. For example, in the abovementioned respective embodiments, taking into consideration a case where a semiconductor laser module 1 is used not only at a ambient temperature higher than normal but also at (ambient temperature) lower (than normal), it was assumed that the thermomodule 5 carries out not only a cooling action but also a heating action. Therefore, in order to feed a current (reverse current) to the thermomodule 5 in the heating direction, a resistor 22 was interposed in the bypass line 21. However, for example, where it is assumed that the semiconductor laser module 1 is used only at ambient temperature higher than normal, that is, where it is assumed that the thermomodule 5 carries out only a cooling action, there may be no need to provide the resistor 22.

In this case, the entire current in the heating direction will flow into the bypass line 21 having a diode 22 which functions as a reverse flow prevention means of the thermomodule 5, with almost no current flowing thereinto. Thereby, it is possible to surely prevent the overcurrent in the heating current from flowing in the thermomodule 5 . Accordingly, it is possible to further securely evade various problems due to an overcurrent flowing into the thermomodule 5 in the heating direction.

Also, as in the above description, where it is assumed that the thermomodule carries out only a cooling action, and therefore it is not necessary to feed a current (reverse current) to the thermomodule 5 in the heating direction, a diode in which the current direction for cooling is made into a forward direction may be provided in series for the thermomodule 5 as a reverse current flow prevention means with no bypass line 21 provided. That is, it may be constructed so that the current flowing into the thermomodule 5 in the heating direction is completely prevented by the diode.

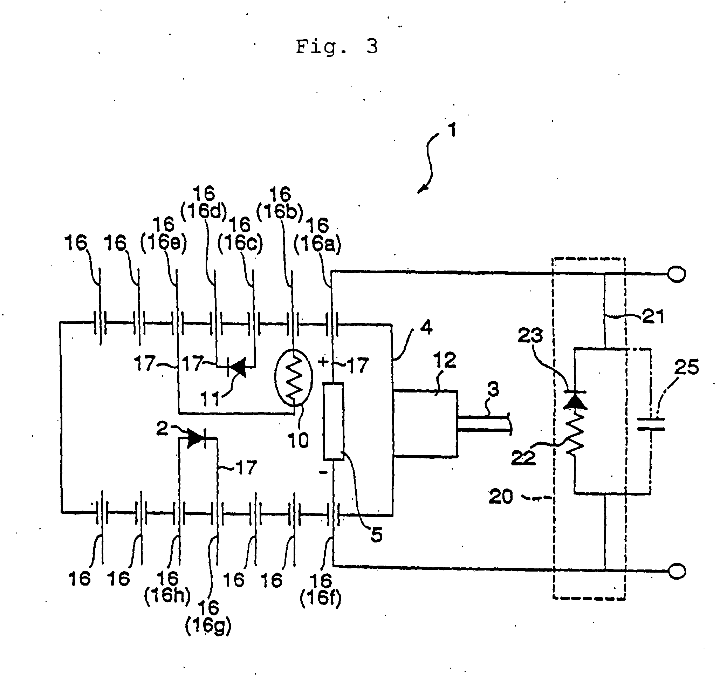

In addition, in the abovementioned respective embodiments, an example is illustrated of a semiconductor laser module with an overcurrent flow limiting feature, in which the abovementioned overcurrent limiting circuit 20 is provided in the package 4. However, for example, as shown in FIG. 3, an overcurrent limiting circuit 20 consisting of a bypass line 21, a resistor 22, and a diode 23, which are covered by a dashed line in Fig. 3, maybe provided between a semiconductor laser module 1 having a similar construction to the prior art (construction shown in FIG. 6) and a drive controlling means for the semiconductor laser module, in order to drive the semiconductor laser module . Still further, a capacitor 25 similar to that in the second embodiment may be provided outside the semiconductor laser module 1 as shown with a dotted line in FIG. 3. An overcurrent limiting circuit 20 and a capacitor 25, which are provided outside the semiconductor laser module shown in FIG. 3, achieve functions similar to those of the overcurrent limiting circuit 20 and capacitor 25 illustrated in the abovementioned respective embodiments, and can bring about similar effects.

Also, in the embodiment, the overcurrent limiting means is not limited to an overcurrent limiting circuit 20 consisting of a bypass line 21, a resistor 22, and a diode 23 as illustrated in Fig. 3, but it can be achieved by other circuit means having similar functions.

A method for driving a semiconductor laser module according to the invention may be applicable to various types of transmission devices incorporating (or equipped with) a semiconductor laser module that controls the temperature of the semiconductor laser element by a Peltier element. In particular, since a semiconductor pumping laser module at the 1480nm and the 980nm band for use in a high output optical fiber amplifier generates much heat, at the semiconductor laser element, and is mostly used in high temperature environment, a current flown into the Peltier module to cool down the semiconductor laser element is very large. Therefore, a method for driving a semiconductor laser module according to the invention is favorable as a method for driving a semiconductor laser module in an optical fiber amplifier.

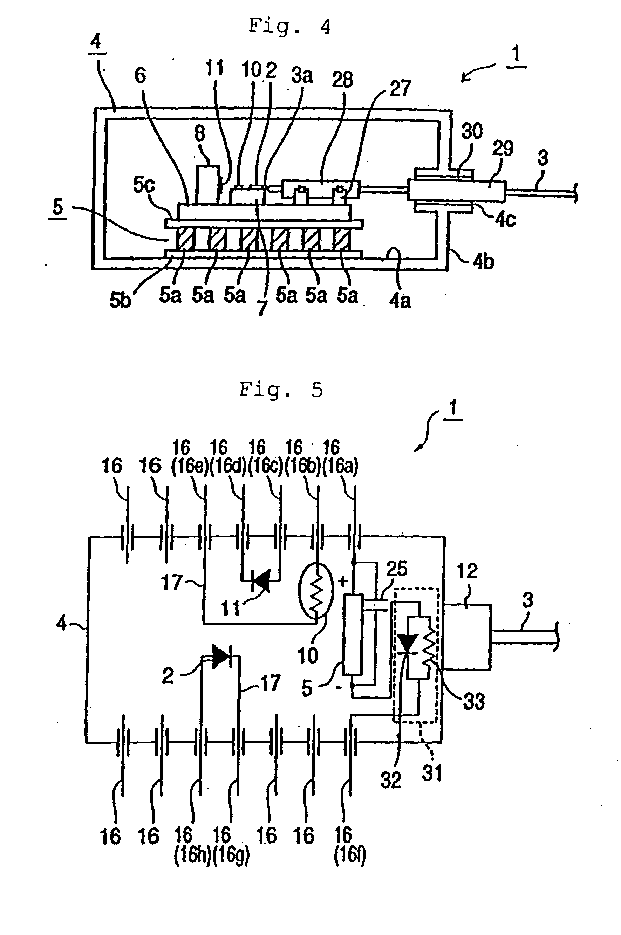

Further, in the abovementioned respective embodiments described above, although a coupling optical system is formed of discrete lenses 9 and 14 from the optical fiber 3 as shown in FIG. 6(a), it may be formed of a lensed optical fiber 3 without utilizing the (discrete) lenses 9 and 14 as shown in Fig. 4. The lensed optical fiber 3 is an optical fiber having a lens 3a for focussing laser light emitted from a semiconductor laser element 2.

The lensed optical fiber 3 is incorporated in the semiconductor laser module 1 as described below. For example, as shown in FIG. 4, a fixing member 27 (for example, made of stainless steel) is attached to the substrate 6, and an optical fiber supporting member 28 is fixed at the fixing member 27 by YAG laser welding, etc. Also, another optical fiber supporting member 29 is fitted into and attached in a through hole 4c formed at the package 4 and is fixed therein by a connection material 30 such as PbSn solder, etc. The optical fiber supporting members 28 and 29 are, respectively, provided with a through hole though which an optical fiber 3 is introduced from outside of the package 4 into the inside thereof with the tip of the optical fiber and the semiconductor laser element 2 being disposed with an adequate spacing to be optically coupled to each other. Constructions other than the above are similar to those shown in FIG. 6(a), and overlapping description thereof is omitted herein.

The optical fiber supporting members 28 and 29 are constructed of, for example, a thermally conductive material such as, for example, Fe-Ni-Co alloy, etc. Strictly speaking, in the construction shown in FIG. 4, a substrate (that is, a plate member 5c) of the thermomodule 2 at the side where the semiconductor laser element 2 is disposed is thermally connected to the optical fiber supporting member 29 via the optical fiber 3. But, since the optical fiber 3 is made of quartz glass having a very thin diameter of 125µm or so, the quantity of heat transmitted from the plate member 5c of the thermomodule 5 to the optical fiber supporting member 29 via the optical fiber 3 is very slight.

Therefore, it can be regarded that the plate member 5c of the thermomodule 5 is thermally isolated from the abovementioned optical fiber supporting member 29. That is, the configuration shown in FIG. 4 is such that discharge of heat from the plate member 5c of the thermomodule 5 to the outside of the package 4 via the optical fiber supporting member 29 is limited. As described above, in a case where an electric wiring configuration shown in FIG. 6 is employed when discharge of the heat is limited, high temperature heat is accumulated in components on the thermomodule 5 and causes various problems if the thermomodule 5 is heated to an extraordinarily high temperature due to an overcurrent flow to the thermomodule 5. To the contrary, by providing the semiconductor laser module with a construction for suppressing an overcurrent flow to the thermomodule 5 as shown in the abovementioned respective embodiments, various problems resulting from the overcurrent flow to the thermomodule 5 can be effectively prevented from occurring.

In addition, a construction shown in FIG. 5 is proposed as still another embodiment of the invention. The example shown in FIG. 5 does not correspond to current control with respect to the thermomodule 5, but it corresponds to voltage control with respect to the thermomodule 5. That is, with this construction, it is possible to avoid problems that result from the application of overvoltage to the thermomodule 5.
That is, in FIG. 5, an overvoltage limiting means 31 is provided in series with respect to the thermomodule 5. The overvoltage limiting means 31 is composed of a parallel connection body consisting of a diode 32 in which the current flow direction in the cooling direction is made forward to be, and a resistor 33.

In the construction shown in FIG. 5, when voltage in the cooling direction is applied to the thermomodule 5, the diode 32 turns on, wherein almost no current flows into the resistor 33, while almost all current flows in the diode 32. Thereby, almost all voltage applied between the lead pins 16a and 16f is applied to the thermomodule 5.

To the contrary, when voltage in the heating direction is applied to the thermomodule 5, the diode 32 turns off,
wherein the current flows into the resistor 33, and the voltage applied between the lead pin 16a and 16f is divided to be applied to the thermomodule 5 and resistor 3. Based thereon, where overvoltage occurs between the lead pins 16a and 16f occurs, the overvoltage is divided to be applied to the thermomodule 5 and the resistor 33. Therefore, it is possible to relieve (limit) the overvoltage application onto the thermomodule 5, and to prevent various problems arising from the application of overvoltage to the thermomodule 5. Any one or both of such overvoltage limiting means and an overcurrent limiting means shown with respect to the abovementioned respective embodiments may be provided in a semiconductor laser module according to the invention.

### INDUSTRIAL APPLICABILITY

As described above, a semiconductor laser module and a method for driving the semiconductor laser module according to the invention is capable of preventing the semiconductor laser and its related components from deteriorating or being damaged, circuit operations from becoming unstable, and the optical system from the semiconductor laser to an optical fiber from misaligning, all of which result from excessive heating, etc., by suppressing overcurrent and overvoltage. Therefore, they are suitable as a means for carrying out highly reliable optical transmissions.

## Claims

1. A semiconductor laser module (1) comprising a semiconductor laser element (2), a thermomodule (5) for adjusting the temperature of the semiconductor laser element (2), an optical fiber (3) optically coupled to laser light emitted from the semiconductor laser element (2),
wherein said thermomodule (5) is constructed so as to variably adjust the temperature of a semiconductor laser in compliance with the amount of a current flowing into said thermomodule (5), and wherein an overcurrent limiting means (20) to suppress an overcurrent flowing into the thermomodule (5) is provided, and wherein said overcurrent limiting means (20) is connected to a current path which provides a current in a heating direction so as to cause said thermomodule (5) to carry out a heating action, wherein said overcurrent limiting means comprises a bypass channel (21) that connects an upstream point and downstream point of said thermomodule (5), thereby bypassing the thermomodule (5); and
wherein said overcurrent limiting means (20) are such as to relieve the flow of an overcurrent in the heating direction into said thermomodule (5) by shunting the current in the heating direction in to said thermomodule (5) and bypass channel (21).

2. A semiconductor laser module as set forth in Claim 1, wherein an overvoltage limiting means to suppress overvoltage application onto said thermomodule (5) is provided, the overvoltage limiting means being connected to the current path so as to cause current flow within the overvoltage limiting means to be in a cooling direction.

3. A semiconductor laser module as set forth in Claim 2, wherein the overcurrent limiting means consist of the bypass channel , a resistor (22) and a diode (23), which are connected in series in the bypass channel.

4. A semiconductor laser module as set forth in Claim 1, wherein a reverse current flow prevention means which prevents a current from flowing into said thermomodule in a direction opposite to that of a drive current of said thermomodule is provided.

5. A semiconductor laser module as set forth in Claim 1, wherein said thermomodule is constructed so that it can change the heating action and the cooling action in compliance with the orientation of the flowing current.

6. A semiconductor laser module as set forth in any one of Claims 1 through 5, wherein said thermomodule is constructed by placing Peltier elements (5a) between the first substrate and second substrate (5b, 5c), a semiconductor laser element is disposed at any one of said first substrate and said second substrate (5b, 5c), and is thermally connected to said thermomodule, and a lens (9) is provided to focus laser light emitted from the semiconductor laser and to introduce said laser light into an optical fiber (3), wherein said lens (9) is thermally connected to a substrate (6) of said thermomodule at the side at which a semiconductor laser element is disposed, via a thermally melting connection material by which a member for attaching said lens (9) is fixed.

7. A semiconductor laser module as set forth in any one of Claims 1 through 5, wherein said optical fiber is a lensed optical fiber (3) in which a lens (3a) to condense laser light emitted from said semiconductor laser element is formed at the tip end portion into which laser light is made incident.

8. A semiconductor laser module as set forth in any one of Claims 1 through 5, wherein said thermomodule is constructed by placing Peltier elements between the first substrate and the second substrate, and a semiconductor element is disposed on any one of the first substrate and the second substrate and is thermally connected to the thermomodule, wherein said semiconductor laser element and thermomodule are disposed and accommodated in a package (4) which is provided with a through hole (4c) communicating from the inside of said package (4) to the outside thereof, an optical fiber supporting member (28/29) consisting of a thermally conducting member is inserted into and fitted in said through hole (4c), the end portion side of an optical fiber (3) is introduced from the outside of said package (4) into the inside thereof via a through hole (4c) provided in said optical fiber supporting member (28/29), the substrate of said thermomodule at the side at which a semiconductor laser element is disposed is thermally isolated from said optical fiber supporting member (28/29), and discharge of heat from the substrate of said thermomodule at the side at which the semiconductor laser element is disposed, to the outside of the package (4) via the optical fiber supporting member (28/29) is limited.

9. A semiconductor laser module as set forth in Claim 6, wherein said thermomodule is constructed by placing Peltier elements between the first substrate and the second substrate, and a semiconductor element is disposed on any one of the first substrate and the second substrate and is thermally connected to the thermomodule,
wherein said semiconductor laser element and thermomodule are disposed and accommodated in a package which is provided with a through hole communicating from the inside of said package to the outside thereof, an optical fiber supporting member consisting of a thermally conducting material is inserted into and fitted in said through hole, the end portion side of an optical fiber is introduced from the outside of said package into the inside thereof via a through hole provided in said optical fiber supporting member, the substrate of said thermomodule at the side at which a semiconductor laser element is disposed, is thermally isolated from said optical fiber supporting member, and discharge of heat from the substrate of said thermomodule at the side at which the semiconductor laser element is disposed to the outside of the package via the optical fiber supporting member is limited.

10. A semiconductor laser module as set forth in any one of Claims 1-7, wherein said thermomodule is constructed by placing Pettier elements between the first substrate and the second substrate, and a semiconductor element is disposed on any one of the first substrate and the second substrate and is thermally connected to the thermomodule,
wherein said semiconductor laser element and thermomodule are disposed and accommodated in a package which is provided with a through hole communicating from the inside of said package to the outside thereof, an optical fiber supporting member consisting of a thermally conducting material is inserted into and fitted in said through hole, the end portion side of an optical fiber is introduced from the outside of said package into the inside thereof via a through hole provided in said optical fiber supporting member, the substrate of said thermomodule at the side at which a semiconductor laser element is disposed, is thermally isolated from said optical fiber supporting member, and discharge of heat from the substrate of said thermomodule at the side at which the semiconductor laser element of said thermomodule is disposed, to the outside of the package via the optical fiber supporting member is limited.

11. A method for driving a semiconductor laser module having a semiconductor laser element, a thermomodule for adjusting the temperature of the semiconductor laser element, and an optical fiber optically coupled to laser light emitted from said semiconductor laser element, comprising the steps of:
thermally connecting said thermomodule to said semiconductor laser element;
adjusting the temperature of the semiconductor laser element in compliance with the amount of a current flowing into the thermomodule;
suppressing the overcurrent flow into the thermomodule by providing an overcurrent limiting means and connecting said overcurrent limiting means to the current path which provides a current in a heating direction so as to cause said thermomodule to carry out a heating action,
wherein said overcurrent limiting means comprise a bypass channel which connects an upstream point and a downstream point of said thermomodule, thereby bypassing said thermomodule; and
wherein said overcurrent limiting means are such as to relieve the overcurrent flow to said thermomodule in the heating direction by shunting the current in the heating direction in to said thermomodule and bypass channel.

12. A method as set forth in Claim 11, further comprising the step of providing a resistor and diode in the bypass channel, which all together construct the overcurrent limiting means.

13. A transmission device comprising a semiconductor laser module as set forth in any one of Claims 1-10.

## Patentansprüche

1. Halbleiterlasermodul (1) mit einem Halbleiterlaserelement (2), einem Thermomodul (5) zum Einstellen der Temperatur des Halbleiterlaserelements (2), einer Lichtleitfaser (3), die optisch an das Laserlicht gekoppelt ist, das vom Halbleiterlaserelement (2) emittiert wird,
wobei das Thermomodul (5) so aufgebaut ist, dass es die Temperatur eines Halbleiterlasers variabel in Übereinstimmung mit der Größe eines Stroms einstellt, der in das Thermomodul (5) fließt, und wobei ein Überstrombegrenzungsmittel (20) zum Unterdrücken eines Überstromflusses in das Thermomodul (5) hinein vorgesehen ist und wobei das Überstrombegrenzungsmittel (20) in einen Strompfad eingebunden ist, der einen Strom in einer Heizrichtung bereitstellt, um so das Thermomodul (5) zu veranlassen, einen Heizbetrieb aufzunehmen, wobei das Überstrombegrenzungsmittel umfasst: einen Umgehungskanal (21), der einen vorgelagerten Punkt und einen nachgelagerten Punkt des Thermomoduls (5) verbindet, wodurch das Thermomodul (5) umgangen wird; und
wobei das Überstrombegrenzungsmittel (20) derart ist, dass es das Fließen eines Überstroms in der Heizrichtung in das Thermomodul (5) freigibt, indem der Strom in der Heizrichtung parallel in das Thermomodul (5) und den Umgehungskanal (21) hinein verteilt wird.

2. Halbleiterlasermodul nach Anspruch 1, wobei ein Überspannungsbegrenzungsmittel zum Unterdrücken einer Überspannungseinwirkung auf das Thermomodul (5) vorgesehen ist, wobei das Überspannungsbegrenzungsmittel mit dem Strompfad so verbunden ist, dass es bewirkt, dass der Stromfluss im Überspannungsbegrenzungsmittel in einer Kühlrichtung vorliegt.

3. Halbleiterlasermodul nach Anspruch 2, wobei das Überstrombegrenzungsmittel aus dem Umgehungskanal, einem Widerstand (22) und einer Diode (23) besteht, die im Umgehungskanal in Reihe geschaltet sind.

4. Halbleiterlasermodul nach Anspruch 1, wobei ein Rückstromflussverhinderungsmittel vorgesehen ist, welches verhindert, dass ein Strom in das Thermomodul hinein in einer Richtung fließt, die zu derjenigen eines Ansteuerungsstroms des Thermomoduls entgegengesetzt ist.

5. Halbleiterlasermodul nach Anspruch 1, wobei das Thermomodul derart aufgebaut ist, dass es den Heizbetrieb und den Kühlbetrieb in Übereinstimmung mit der Richtung des fließenden Stromes abwechseln kann.

6. Halbleiterlasermodul nach einem der Ansprüche 1 bis 5,
wobei das Thermomodul aufgebaut ist durch Platzieren von Peltier-Elementen (5a) zwischen dem ersten Substrat und zweiten Substrat (5b, 5c), wobei ein Halbleiterlaserelement an einem beliebigen von dem ersten Substrat und dem zweiten Substrat (5b, 5c) angeordnet und thermisch mit dem Thermomodul verbunden ist, und
wobei eine Linse (9) vorgesehen ist, um das vom Halbleiterlaser emittierte Licht zu bündeln und das Laserlicht in eine Lichtleitfaser (3) einzukoppeln, wobei die Linse (9) über ein thermisch schmelzendes Verbindungsmaterial, durch welches ein Bauteil zum Anfügen der Linse (9) fixiert ist, thermisch mit einem Substrat (6) des Thermomoduls an der Seite verbunden ist, an der ein Halbleiterlaserelement angeordnet ist.

7. Halbleiterlasermodul nach einem der Ansprüche 1 bis 5,
wobei die Lichtleitfaser eine linsenbehaftete Lichtleitfaser (3) ist, in der eine Linse (3a) am Kopfendteil ausgebildet ist, in den das Laserlicht zum Einfall gebracht wird, um das vom Halbleiterlaserelement emittierte Laserlicht zu bündeln.

8. Halbleiterlasermodul nach einem der Ansprüche 1 bis 5,
wobei das Thermomodul aufgebaut ist durch Platzieren von Peltier-Elementen zwischen dem ersten Substrat und dem zweiten Substrat und ein Halbleiterlaserelement in einem beliebigen von dem ersten Substrat und dem zweiten Substrat angeordnet und thermisch mit dem Thermomodul verbunden ist, wobei das Halbleiterlaserelement und das Thermomodul in einer Baugruppe (4) angeordnet und untergebracht sind, die mit einem Durchgangsloch (4c) versehen ist, das eine Verbindung von dem Inneren der Baugruppe (4) zu deren Außenseite herstellt, wobei ein Lichtleitfaser-Halterungselement (28/29), das aus einem thermisch leitenden Bauteil besteht, in das Durchgangsloch (4c) eingeführt und eingepasst ist, wobei die Endabschnittsseite einer Lichtleitfaser (3) von der Außenseite der Baugruppe (4) her in deren Inneres durch ein Durchgangsloch (4c) eingeführt ist, das in dem Lichtleitfaser-Halterungselement (28/29) vorgesehen ist, wobei das Substrat des Thermomoduls an der Seite, an der ein Halbleiterlaserelement angeordnet ist, gegenüber dem Lichtleitfaser-Halterungselement (28/29) thermisch isoliert ist und die Wärmeableitung vom Substrat des Thermomoduls an der Seite, an der das Halbleiterlaserelement angeordnet ist, zur Außenseite der Baugruppe (4) über das Lichtleitfaser-Halterungselement (28/29) eingeschränkt ist.

9. Halbleiterlasermodul nach Anspruch 6, wobei das Thermomodul aufgebaut ist durch Platzieren von Peltier-Elementen zwischen dem ersten Substrat und dem zweiten Substrat und ein Halbleiterlaserelement in einem beliebigen von dem ersten Substrat und dem zweiten Substrat angeordnet und thermisch mit dem Thermomodul verbunden ist,
wobei das Halbleiterlaserelement und das Thermomodul in einer Baugruppe angeordnet und untergebracht sind, die mit einem Durchgangsloch versehen ist, das eine Verbindung von dem Inneren der Baugruppe zu deren Außenseite herstellt, wobei ein Lichtleitfaser-Halterungselement, das aus einem thermisch leitenden Bauteil besteht, in das Durchgangsloch eingeführt und eingepasst ist, wobei die Endabschnittsseite einer Lichtleitfaser von der Außenseite der Baugruppe her in deren Inneres durch ein Durchgangsloch eingeführt ist, das in dem Lichtleitfaser-Halterungselement vorgesehen ist, wobei das Substrat des Thermomoduls an der Seite, an der ein Halbleiterlaserelement angeordnet ist, gegenüber dem Lichtleitfaser-Halterungselement thermisch isoliert ist und die Wärmeableitung vom Substrat des Thermomoduls an der Seite, an der das Halbleiterlaserelement angeordnet ist, zur Außenseite der Baugruppe über das Lichtleitfaser-Halterungselement eingeschränkt ist.

10. Halbleiterlasermodul nach einem der Ansprüche 1-7,
wobei das Thermomodul aufgebaut ist durch Platzieren von Peltier-Elementen zwischen dem ersten Substrat und zweiten Substrat und ein Halbleiterlaserelement in einem beliebigen von dem ersten Substrat und dem zweiten Substrat angeordnet und thermisch mit dem Thermomodul verbunden ist,
wobei das Halbleiterlaserelement und das Thermomodul in einer Baugruppe angeordnet und untergebracht sind, die mit einem Durchgangsloch versehen ist, das eine Verbindung von dem Inneren der Baugruppe zu deren Außenseite herstellt, wobei ein Lichtleitfaser-Halterungselement, das aus einem thermisch leitenden Bauteil besteht, in das Durchgangsloch eingeführt und eingepasst ist, wobei die Endabschnittsseite einer Lichtleitfaser von der Außenseite der Baugruppe her in deren Inneres durch ein Durchgangsloch eingeführt ist, das in dem Lichtleitfaser-Halterungselement vorgesehen ist, wobei das Substrat des Thermomoduls an der Seite, an der ein Halbleiterlaserelement angeordnet ist, gegenüber dem Lichtleitfaser-Halterungselement thermisch isoliert ist und die Wärmeableitung vom Substrat des Thermomoduls an der Seite, an der das Halbleiterlaserelement des Thermoduls angeordnet ist, zur Außenseite der Baugruppe über das Lichtleitfaser-Halterungselement eingeschränkt ist.

11. Verfahren zum Betreiben eines Halbleiterlasermoduls, das ein Halbleiterlaserelement, ein Thermomodul zum Einstellen der Temperatur des Halbleiterlaserelements und eine Lichtleitfaser aufweist, die optisch an das Laserlicht gekoppelt ist, das von dem Halbleiterlaserelement emittiert wird, die Schritte umfassend:
thermisches Verbinden des Thermomoduls mit dem Halbleiterlaserelement;
Einstellen der Temperatur des Halbleiterlaserelements in Übereinstimmung mit der Größe des Stromes, der in das Thermomodul fließt;
Unterdrücken des Überstromflusses in das Thermomodul durch Bereitstellen eines Überstrombegrenzungsmittels und Einbinden des Überstrombegrenzungsmittels in den Strompfad, der einen Strom in einer Heizrichtung so bereitstellt, dass das Thermomodul veranlasst wird, einen Heizbetrieb aufzunehmen;
wobei das Überstrombegrenzungsmittel umfasst:
einen Umgehungskanal, der einen vorgelagerten Punkt und einen nachgelagerten Punkt des Thermomoduls verbindet, wodurch das Thermomodul umgangen wird;
wobei das Überstrombegrenzungsmittel derart ist, dass es den Überstromfluss zum Thermomodul in der Heizrichtung freigibt, indem der Strom in der Heizrichtung parallel in das Thermomodul und den Umgehungskanal hinein verteilt wird.

12. Verfahren nach Anspruch 11, ferner den Schritt zum Bereitstellen eines Widerstands und einer Diode im Umgehungskanal umfassend, die alle zusammen das Überstrombegrenzungsmittel aufbauen.

13. Übertragungsvorrichtung, ein Halbleiterlasermodul nach einem der Ansprüche 1-10 umfassend.

## Revendications

1. Module laser à semi-conducteurs (1) comprenant un élément laser à semi-conducteurs (2), un module thermique (5) pour régler la température de l'élément laser à semi-conducteurs (2), une fibre optique (3) optiquement couplée à la lumière laser émise à partir de l'élément laser à semi-conducteurs (2),
dans lequel ledit module thermique (5) est construit de manière à régler de façon variable la température d'un laser à semi-conducteurs conformément à la quantité de courant circulant dans ledit module thermique (5), et dans lequel un moyen de limitation de surintensité (20) permettant de supprimer une surintensité circulant dans le module thermique (5) est fourni, et dans lequel ledit moyen de limitation de surintensité (20) est connecté à un trajet de courant qui fournit un courant dans une direction de chauffage de manière à faire en sorte que ledit module thermique (5) exécute une action de chauffage, dans lequel ledit moyen de limitation de surintensité (20) comprend : un canal de dérivation (21) qui connecte un point en amont et un point en aval dudit module thermique (5), ce qui permet de contourner le module thermique (5) ; et
dans lequel ledit moyen de limitation de surintensité (20) est conçu de manière à libérer la circulation d'une surintensité dans la direction de chauffage dans ledit module thermique (5) en court-circuitant le courant dans la direction de chauffage dans ledit module thermique (5) et ledit canal de dérivation (21).

2. Module laser à semi-conducteurs selon la revendication 1, dans lequel un moyen de limitation de surtension permettant de supprimer l'application de surtension sur ledit module thermique (5) est fourni, le moyen de limitation de surtension étant connecté au trajet de courant de manière à faire en sorte que le courant circule à l'intérieur du moyen de limitation de surtension pour être dans une direction de refroidissement.

3. Module laser à semi-conducteurs selon la revendication 2, dans lequel le moyen de limitation de surintensité consiste en le canal de dérivation, une résistance (22) et une diode (23) qui sont connectées en série dans le canal de dérivation.

4. Module laser à semi-conducteurs selon la revendication 1, dans lequel un moyen de prévention de circulation de courant inverse qui permet d'empêcher qu'un courant ne circule dans ledit module thermique dans une direction opposée à celle d'un courant d'attaque dudit module thermique est fourni.

5. Module laser à semi-conducteurs selon la revendication 1, dans lequel ledit module thermique est construit de manière à pouvoir modifier l'action de chauffage et l'action de refroidissement conformément à l'orientation du courant en circulation.

6. Module laser à semi-conducteurs selon l'une quelconque des revendications 1 à 5, dans lequel ledit module thermique est construit en plaçant des éléments Peltier (5a) entre le premier substrat et le second substrat (5b, 5c), un élément laser à semi-conducteurs est disposé soit au niveau dudit premier substrat soit au niveau dudit second substrat (5b, 5c) et est thermiquement connecté audit module thermique, et une lentille (9) est fournie afin de focaliser la lumière laser émise à partir du laser à semi-conducteurs et afin d'introduire ladite lumière laser dans une fibre optique (3), ladite lentille (9) étant thermiquement connectée à un substrat (6) dudit module thermique du côté où se trouve un élément laser à semi-conducteurs, via un matériau de connexion fondant sous l'effet de la chaleur au moyen duquel un élément permettant de fixer ladite lentille (9) est fixé.

7. Module laser à semi-conducteurs selon l'une quelconque des revendications 1 à 5, dans lequel ladite fibre optique est une fibre optique à lentille (3) dans laquelle une lentille (3a) permettant de condenser la lumière laser émise à partir dudit élément laser à semi-conducteurs est formée au niveau de la partie d'extrémité en pointe dans laquelle la lumière laser est rendue incidente.

8. Module laser à semi-conducteurs selon l'une quelconque des revendications 1 à 5, dans lequel ledit module thermique est construit en plaçant des éléments Peltier entre le premier substrat et le second substrat, et un élément à semi-conducteurs est disposé soit sur le premier substrat soit sur le second substrat et est thermiquement connecté au module thermique, dans lequel ledit élément laser à semi-conducteurs et ledit module thermique sont disposés et logés dans un boîtier (4) qui est pourvu d'un trou traversant (4c) communiquant depuis l'intérieur dudit boîtier (4) jusqu'à l'extérieur de ce dernier, un élément de support de fibre optique (28/29) consistant en un élément thermoconducteur est inséré dans ledit trou traversant (4c) et y est logé, la partie d'extrémité d'une fibre optique (3) est introduite depuis l'extérieur dudit boîtier (4) jusqu'à l'intérieur de ce dernier via un trou traversant (4c) disposé dans ledit élément de support de fibre optique (28/29), le substrat dudit module thermique du côté où se trouve un élément laser à semi-conducteurs est thermiquement isolé dudit élément de support de fibre optique (28/29), et la perte de chaleur depuis le substrat dudit module thermique du côté où se trouve l'élément laser à semi-conducteurs vers l'extérieur du boîtier (4) via l'élément de support de fibre optique (28/29) est limitée.

9. Module laser à semi-conducteurs selon la revendication 6, dans lequel ledit module thermique est construit en plaçant des éléments Peltier entre le premier substrat et le second substrat, et un élément à semi-conducteurs est disposé soit sur le premier substrat soit sur le second substrat et est thermiquement connecté au module thermique,
dans lequel ledit élément laser à semi-conducteurs et ledit module thermique sont disposés et logés dans un boîtier qui est pourvu d'un trou traversant communiquant depuis l'intérieur dudit boîtier jusqu'à l'extérieur de ce dernier, un élément de support de fibre optique consistant en un matériau thermoconducteur est inséré dans ledit trou traversant et y est logé, la partie d'extrémité d'une fibre optique est introduite depuis l'extérieur dudit boîtier jusqu'à l'intérieur de ce dernier via un trou traversant disposé dans ledit élément de support de fibre optique, le substrat dudit module thermique du côté où se trouve un élément laser à semi-conducteurs est thermiquement isolé dudit élément de support de fibre optique, et la perte de chaleur depuis le substrat dudit module thermique du côté où se trouve l'élément laser à semi-conducteurs vers l'extérieur du boîtier via l'élément de support de fibre optique est limitée.

10. Module laser à semi-conducteurs selon l'une quelconque des revendications 1 à 7, dans lequel ledit module thermique est construit en plaçant des éléments Peltier entre le premier substrat et le second substrat, et un élément à semi-conducteurs est disposé soit sur le premier substrat soit sur le second substrat et est thermiquement connecté au module thermique,
dans lequel ledit élément laser à semi-conducteurs et ledit module thermique sont disposés et logés dans un boîtier qui est pourvu d'un trou traversant communiquant depuis l'intérieur dudit boîtier jusqu'à l'extérieur de ce dernier, un élément de support de fibre optique consistant en un matériau thermoconducteur est inséré dans ledit trou traversant et y est logé, la partie d'extrémité d'une fibre optique est introduite depuis l'extérieur dudit boîtier jusqu'à l'intérieur de ce dernier via un trou traversant disposé dans ledit élément de support de fibre optique, le substrat dudit module thermique du côté où se trouve un élément laser à semi-conducteurs est thermiquement isolé dudit élément de support de fibre optique, et la perte de chaleur depuis le substrat dudit module thermique du côté où se trouve l'élément laser à semi-conducteurs dudit module thermique vers l'extérieur du boîtier via l'élément de support de fibre optique est limitée.

11. Procédé permettant de piloter un module laser à semi-conducteurs possédant un élément laser à semi-conducteurs, un module thermique pour régler la température de l'élément laser à semi-conducteurs, et une fibre optique optiquement couplée à la lumière laser émise à partir dudit élément laser à semi-conducteurs, comprenant les étapes consistant à :
connecter thermiquement ledit module thermique audit élément laser à semi-conducteurs ;
régler la température de l'élément laser à semi-conducteurs conformément à la quantité de courant circulant dans le module thermique ;
supprimer la circulation d'une surintensité dans le module thermique en fournissant un moyen de limitation de surintensité et en connectant ledit moyen de limitation de surintensité au trajet de courant qui fournit un courant dans une direction de chauffage de manière à faire en sorte que ledit module thermique exécute une action de chauffage,
et
dans lequel ledit moyen de limitation de surintensité comprend un canal de dérivation qui connecte un point en amont et un point en aval dudit module thermique, ce qui permet de contourner le module thermique ;
dans lequel ledit moyen de limitation de surintensité est conçu de manière à libérer la circulation d'une surintensité vers ledit module thermique dans la direction de chauffage en court-circuitant le courant dans la direction de chauffage dans ledit module thermique et ledit canal de dérivation.

12. Procédé selon la revendication 11, comprenant en outre l'étape consistant à fournir une résistance et une diode dans le canal de dérivation qui ensemble composent le moyen de limitation de surintensité.

13. Dispositif de transmission comprenant un module laser à semi-conducteurs selon l'une quelconque des revendications 1 à 10.
